# EUROPÄISCHE PATENTANMELDUNG

(11) **EP 1 411 152 A2**
(43) Veröffentlichungstag der Anmeldung: **21.04.2004**
(21) Anmeldenummer: 02024418.2
(22) Anmeldetag: 28.10.2002
(51) Int. Cl.: C30B 23/02, C04B 41/89, H01L 39/24

(54) **Schichtmaterial sowie Verfahren zur Verbesserung der Stromtragfähigkeit von Hochtemperatur-Supraleiter-Dünnschichten**

(30) Priorität: 15.10.2002 DE 10248025
(71) Anmelder: Theva Dünnschichttechnik GmbH, 85737 Ismaning (DE)
(72) Erfinder: Metzger, Ralf, Dipl.-Phys., 80805 München (DE); Numssen, Kai, Dr., 80992 München (DE); Kinder, Helmut, Prof. Dr., 85354 Freising (DE)
(74) Vertreter: Hess, Peter K., Dipl.-Phys.

(57) **Zusammenfassung**

In einem erfindungsgemäßen Verfahren zur Herstellung einer Hochtemperatur-Supraleiterschicht wird ein polykristallines oder amorphes Substrat (1) mittels Beschichtung unter schräger Depositionsrichtung (ISD) mit einer biaxial texturierten Pufferschicht (2) versehen. Oberhalb dieser Pufferschicht wird weiterhin eine Schicht (4a,4b) umfassend RBCO aufgebracht, wobei R ein Element der Ordnungszahl 57-64 oder eine Mischung aus zumindest zweien dieser Elemente ist. Weiterhin ist eine erfindungsgemäße Hochtemperatur-supraleitende Schichtstruktur offenbart, aufweisend ein polykristallines oder amorphes Substrat (1), eine biaxial texturierte Pufferschicht (2), die mittels Beschichtung unter schräger Depositiorisrichtung (ISD) aufgebracht wurde und eine Schicht (4a,4b) umfassend RBCO, wobei R ein Element der Ordnungszahl 57-64 oder eine Mischung aus zumindest zweien dieser Elemente ist.

## Beschreibung

### 1. Technisches Gebiet

Die vorliegende Erfindung betrifft ein Verfahren zur Herstellung einer Hochtemperatur-Supraleiterschicht mit hoher kritischer Stromdichte sowie ein Schichtmaterial mit einer Hochtemperatur-Supraleiter-Dünnschicht

### 2. Stand der Technik

Dünnschichten aus Hochtemperatursupraleitern (HTS) werden für Anwendungen in der Energietechnik eingesetzt. Das Verschwinden des elektrischen Widerstandes unterhalb der Sprungtemperatur T_{c} ermöglicht eine Erhöhung des Wirkungsgrades verschiedenster Vorrichtungen zur Speicherung, Umwandlung oder zum Transport von elektrischer Energie.

Idealerweise sollte dabei die HTS-Dünnschicht auf ein dünnes Metallband aufgebracht werden (HTS-Bandleiter). Ein solcher HTS-Bandleiter kann dann in etablierten Anwendungen Kupferleitungen ersetzen, die mit hohen Strömen belastet sind. Diese hohen Ströme führen im Kupfer zu starken ohmschen Verlusten. Mit dem Einsatz von Supraleitern können diese Verluste vermieden werden.

Weiter können auch Anwendungen, bei denen bereits heute das Kupfer durch konventionelle Supraleiter ersetzt ist, verbessert werden. Die HTS erlauben eine deutlich höhere Betriebstemperatur und halten höheren Magnetfeldern stand. Die daraus resultierende Verringerung des Kühlaufwandes führt dann zu einer Erhöhung des Wirkungsgrades.

Daneben gibt es auch Anwendungen, in denen das Substrat elektrisch nicht leitend sein soll. In diesen Fällen können anstelle des Metallbandes andere Substrate wie z.B. Keramiken verwendet werden.

Für technische Anwendungen interessiert in der Regel besonders die Stromtragfähigkeit des Supraleiters. Als Maß dafür dient die kritische Stromdichte j_{c}, definiert als die Stromstärke pro Leiterquerschnitt, die ein elektrisches Feld von 1µV/cm im Supraleiter erzeugt. Üblicherweise wird j_{c} bei einer Temperatur von 77,4 K angegeben (Siedepunkt des flüssigen Stickstoffs).

Als Supraleiter-Material verwendet man heute meist das YBa₂Cu₃O₇ (YBCO) mit einer Sprungtemperatur von knapp über 92 K und kritischen Stromdichten von einigen MA/cm². Für die Herstellung von YBCO-Dünnschichten gibt es mehrere etablierte Verfahren, wie z.B. das im Patent mit der Nummer DE 196 80 845 beschriebene. YBCO-Dünnschichten auf Einkristallen sind damit bis zu 200 mm Durchmesser kommerziell verfügbar.

Grundsätzlich kann das Yttrium im YBCO durch die meisten Seltenen Erden, insbesondere Dy, Gd, Eu, Sm, Nd, oder La ersetzt werden, wie es in den Patenten mit den Nummern DE 37 908 72 C2 oder GB 2 228 928 B beschrieben ist. Mit zunehmendem Ionenradius der Seltenen Erde verbessern sich dabei die Sprungtemperaturen nahezu linear bis hin zum Nd auf knapp über 96 K. Dem gegenüber stehen aber größere Anforderungen an die Einhaltung der idealen Stöchiometrie, da bei Anweichung von der Idealstoichiometrie seltene Erden mit großem Ionenradius auch Ba-Plätze im Kristallgitter besetzen können.

Ausnahmen in der Serie der Seltenen Erden stellen die Elemente Cer (Ce) und Praseodym (Pr) dar. Da Ce in Verbindungen bevorzugt vierwertig vorliegt, gibt es keine dem YBCO homologe Ce-Verbindung. PrBCO existiert zwar, ist jedoch nur bei Verwendung extrem reinen Pr supraleitend und auch dann wurde Supraleitung nur in Teilen der Probe beobachtet. In den meisten Fällen sorgen bereits geringfügige Verunreinigungen dafür, dass PrBCO einen halbleitenden Widerstandsverlauf zeigt und nicht supraleitend wird.

Von den supraleitenden RBa₂Cu₃O₇ (RBCO) - Verbindungen zeigen nur solche, die als einkristallin geordnete (epitaktische) HTS-Dünnschichten vorliegen, eine hohe Stromtragfähigkeit. Ursache ist die Tatsache, dass die Supraleitung zum einen in den CuO₂-Ebenen der geschichteten Verbindung konzentriert ist und zum anderen die Kohärenzlänge der supraleitenden Ladungsträger (Cooper-Paare) extrem kurz ist und in der Größenordnung einiger Gitterkonstanten liegt. Somit beeinträchtigen selbst Korngrenzen mit Winkeln über 10° die Stromtragfähigkeit beträchtlich und führen zu einer Reduktion der kritischen Stromdichte um eine Größenordnung.

Zur Herstellung wohlgeordneter, epitaktischer Schichten bedarf es deswegen entweder eines texturierten Substrats oder einer texturierten Pufferschicht auf untexturierten Substraten. Für die Herstellung von HTS-beschichteten Metallbändern kommen zum Zwecke der Texturbildung drei verschiedene Verfahren in Betracht:
- RABiTS (Rolling Assisted Biaxally Textured Substrates): Erzeugt die Texturierung des Substrats durch ein spezielles Walz- oder Ziehverfahren.
- IBAD (Ionenstrahlunterstütze Depositon): Erzeugt die Texturierung einer Pufferschicht aus Y-stabilisertem ZrO₂ (YSZ), MgO oder anderen Oxiden durch einen schräg einfallenden Ar-Ionenstrahl, der während der Schichtdeposition für eine Ausrichtung sorgt. Dieses Verfahren ist in der Patentanmeldung W098/17846 oder dem Patent mit der Nummer US 6,214,772 beschrieben.
- ISD (Inclined Substrate Deposition): Erzeugt die Texturierung einer oxidischen Pufferschicht vorzugsweise aus YSZ, MgO oder CeO₂ durch Beschichtung unter schräger Depositionsrichtung. Solch ein Verfahren ist beispielsweise in den Patentanmeldungen mit den Nummern EP 669 411 A2 und DE 197 54 475 A1 beschrieben.

Die drei Verfahren unterscheiden sich nicht nur im zugrunde liegenden Orientierungsmechanismus, sondern auch in der Qualität der Textur sowie der Kostenstruktur und Wirtschaftlichkeit. Während mit den ersten beiden Verfahren zumindest auf kurzen und mittellangen Bandstücken (einige Meter) bereits kritische Stromdichten von über 2 MA/cm² erreicht wurden, liegen beim potentiell billigsten ISD-Verfahren die bislang erreichten Bestwert bei nur 0.8 MA/cm². Dieses Ergebnis wurde bereits 1998 erreicht und konnte seitdem nicht mehr verbessert werden. Die erzielten Sprungtemperaturen der Supraleiterschicht lagen auf den ISD-Substraten immer knapp 3 K niedriger als bei vergleichbaren Dünnschichten auf Einkristallen.

Das ISD-Verfahren ist einfacher und damit wirtschaftlicher als das IBAD-Verfahren und in der Wahl des Substratmaterials weniger eingeschränkt als das RABiTS-Verfahren (für das bevorzugt Ni, Ag und Legierungen dieser Metalle in Frage kommen), kommt aber aus ungeklärter Ursache nach dem Stand der Technik nur auf zu geringe kritische Stromdichten.

Die Stromtragfähigkeit ist jedoch das entscheidende Maß für die Bandleiter. Eine um einen Faktor drei geringere Stromtragfähigkeit führt dazu, dass drei mal so viel Band benötigt wird, um den gleichen Strom zu transportieren. Hinzu kommt eine Verdreifachung des Leiterquerschnitts, die in vielen Anwendungen stören würde. Es ist also von zentraler Bedeutung, die kritische Stromdichte auf technischen Substraten, insbesondere den ISD-beschichteten Substraten, zu erhöhen.

Verwendet man anstelle des Yttrium (Ionenradius 1,01 Å) ein Element oder eine Mischung aus Elementen der Nebengruppe der Seltene Erden (Lanthaniden) mit größerem Ionenradius > 1,05 Å (z.B. Gd, Eu, Sm, Nd, La), ergibt sich nach dem Stand der Technik auf Einkristallen eine Erhöhung der Sprungtemperatur, ohne jedoch die Stromtragfähigkeit wesentlich zu verbessern. Die Angaben zum Ionenradius beruhen auf die Veröffentlichungen R.D. Shannon, Acta Cryst. A32, S. 751-767 (1976) und O. Greis, T. Petzel, Z. anorg. Chem. 403, S. 1-22, (1974). Wichtig ist in diesem Zusammenhang die systematische Vergrößerung des Ionenradius mit fallender Ordnungszahl.

Es ist daher die Aufgabe der vorliegenden Erfindung, ein gegenüber dem Stand der Technik hinsichtlich der Stromtragfähigkeit verbessertes HTS-Schichtsystem bereitzustellen.

### 3. Zusammenfassung der Erfindung

In einem erfindungsgemäßen Verfahren zur Herstellung einer Hochtemperatur-Supraleiterschicht wird ein polykristallines oder amorphes Substrat mittels Beschichtung unter schräger Depositionsrichtung (ISD) mit einer biaxial texturierten Pufferschicht versehen. Oberhalb dieser Pufferschicht wird weiterhin eine Schicht umfassend RBCO (RBa₂Cu₃O₇) aufgebracht, wobei R ein Element der Ordnungszahl 57-64 oder eine Mischung aus zumindest zweien dieser Elemente ist.

Eine erfindungsgemäße Hochtemperatur-supraleitende Schichtstruktur weist ein polykristallines oder amorphes Substrat, eine biaxial texturierte Pufferschicht, die mittels Beschichtung unter schräger Depositionsrichtung (ISD) auf das Substrat aufgebracht wurde und eine Schicht umfassend RBCO (RBa₂Cu₃O₇) auf, wobei R ein Element der Ordnungszahl 57-64 oder eine Mischung aus zumindest zweien dieser Elemente ist.

In einer bevorzugten Ausführungsform ist R eines der Element La, Pr, Nd, Sm, Eu oder Gd oder eine Mischung aus zumindest zweien dieser Elemente. Besonders bevorzugt steht R für Nd.

Die Verwendung von Seltenen Erden mit großen Ionenradien (> 1,05 Å), d.h. Elemente der Ordnungszahlen 57-64, ermöglicht die Abscheidung hochwertiger HTS-Dünnschichten auf technischen Substraten mit orientierungsbildender Textur. Die so erzeugten HTS-Dünnschichten weisen eine wesentlich verbesserte Stromtragfähigkeit auf, als konventionelle YBCO-HTS-Dünnschichten.

Bei den günstigen ISD-Substraten ergeben sich besondere technische Vorteile, so dass sie durch Verwendung von RBCO als Supraleiter überhaupt erst kommerziell interessant werden.

In einer weiteren bevorzugten Ausführungsform weißt die Schicht umfassend RBCO ferner Yttrium auf.

Weiterhin wird in einer bevorzugten Ausführungsform der Erfindung oberhalb der RBCO-Schicht mindestens eine weitere Schicht umfassend XBCO (XBa₂Cu₃O₇) aufgebracht, wobei X ein Element der Ordnungszahl 57-71, Yttrium oder eine Mischung aus zumindest zweien dieser Elemente ist.

In einer weiteren bevorzugten Ausführungsform ist X eines der Elemente La, Nd, Sm, Eu oder Gd oder eine Mischung aus zumindest zweien dieser Elemente. Bevorzugt ist X Yttrium.

Dabei wirkt die RBCO-Schicht bevorzugt als eine Keimschicht und die XBCO-Schicht als Funktionsschicht. Damit kann sogar schon eine substantielle Verbesserung der supraleitenden Eigenschaften dadurch erzielt werden, dass nicht die gesamte Schicht, sondern nur eine dünne Zwischenschicht aus einem Material mit großem Seltenerd-Atom zwischen dem Substrat und der eigentlichen XBCO-Funktionsschicht verwendet wird. Besonders bevorzugt wird die RBCO-Schicht, wenn sie als Keimschicht verwendet wird, bis zu einer Dicke von 5-100 nm aufgebracht.

In einer bevorzugten Ausführungsform wird zwischen der Pufferschicht und der RBCO-Schicht eine biaxial texturierte Deckschicht aufgebracht. Es ist aber ebenfalls bevorzugt, die RBCO-Schicht unmittelbar auf die Pufferschicht aufzubringen.

Bevorzugt weist die Hochtemperatur-Supraleiterschicht eine kritische Stromdichte von mindestens 1 MA/cm² auf.

In einer weiteren bevorzugten Ausführungsform umfasst das Substrat eine polykristalline Keramik, die insbesondere Al₂O₃, YSZ oder MgO aufweist. Weiterhin bevorzugt umfasst das Substrat ein polykristallines Metallband, das insbesondere Edelstahl oder Hastelloy aufweist.

Weitere bevorzugte Ausführungsformen der Erfindung bilden den Gegenstand weiterer abhängiger Patentansprüche.

### 4. Kurze Beschreibung der Zeichnung

- Fig. 1: zeigt eine Schichtstapelfolge einer bevorzugten Ausführungsform eines erfindungsgemäßen HTS-Schichtsystems;
- Fig. 2: zeigt eine Schichtstapelfolge einer weiteren bevorzugten Ausführungsform eines erfindungsgemäßen HTS-Schichtsystems mit Keimschicht und Funktionsschicht.
- Fig. 3: zeigt eine Schichtstapelfolge einer weiteren bevorzugten Ausführungsform eines erfindungsgemäßen HTS-Schichtsystems mit Deckschicht auf der ISD-Pufferschicht.
- Fig. 4: zeigt eine Schichtstapelfolge einer weiteren bevorzugten Ausführungsform eines erfindungsgemäßen HTS-Schichtsystems mit Deckschicht auf der ISD-Pufferschicht, Keimschicht und Funktionsschicht.

### 5. Detaillierte Beschreibung der bevorzugten Ausführungsformen

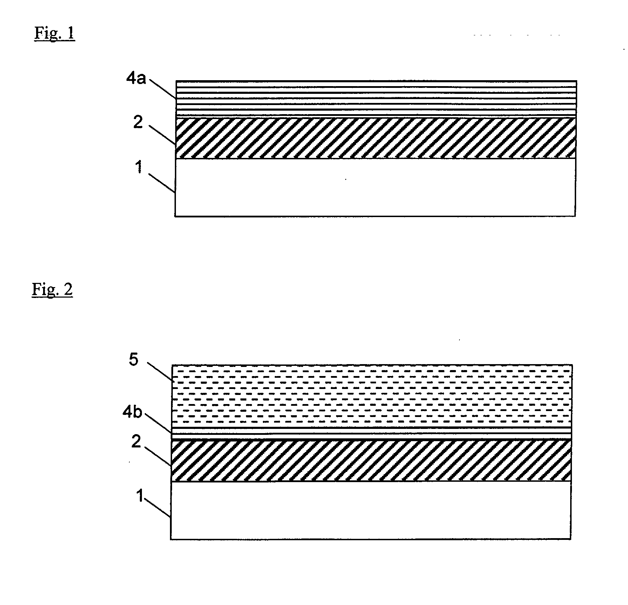

In Figur 1 ist eine Schichtstapelfolge eines HTS-Schichtsystems dargestellt. Auf einem polykristallinen oder amorphen Substrat 1 befindet sich eine durch Schrägdeposition nach DE 197 54 475 A1 (ISD-Verfahren) aufgebrachte biaxial texturierte Pufferschicht 2.

Die RBCO-Schicht 4a bildet die zur Leitung des Suprastroms benötigte Funktionsschicht mit hoher Stromdichte.

Hier und im folgenden steht R für ein Element der Ordnungszahl 57-64 oder Mischungen dieser Elemente. Bevorzugt steht R für eines der Element La, Pr, Nd, Sm, Eu oder Gd oder eine Mischung aus zumindest zweien dieser Elemente. Besonders bevorzugt steht R für Nd.

Die Schicht 4a kann zusätzlich zu dem RBCO ferner auch Yttrium aufweisen.

Eine weitere Schichtstapelfolge des HTS-Schichtsystems ist in Figur 2 dargestellt. Auf einem polykristallinen oder amorphen Substrat 1 befindet sich wiederum eine durch Schrägdeposition nach DE 197 54 475 A1 aufgebrachte biaxial texturierte Pufferschicht 2.

Eine dünne RBCO-Schicht 4b dient als Keimschicht, die das Wachstum und die Stromtragfähigkeit der darauf folgenden XBCO-Schicht 5 die als Funktionsschicht mit hoher Stromdichte fungiert, verbessert.

Hier und im folgenden steht X für ein Element der Ordnungszahl 57-71, Yttrium oder eine Mischung aus zumindest zweien dieser Elemente. Bevorzugt steht X für eines der Elemente La, Nd, Sm, Eu oder Gd oder eine Mischung aus zumindest zweien dieser Elemente. Weiterhin bevorzugt steht X für Yttrium.

Auch die Schicht 4b kann zusätzlich zu dem RBCO ferner auch Yttrium aufweisen.

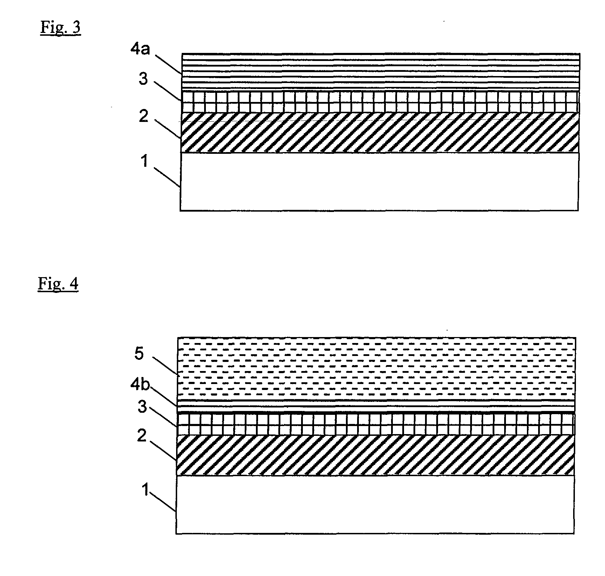

Die Figuren 3 und 4 zeigen weitere bevorzugte Ausführungsbeispiele der vorliegenden Erfindung. In diesen Ausführungsformen wird die biaxial texturierte Pufferschicht 2 jeweils mit einer ebenfalls biaxial texturierten Deckschicht 3 versehen, die eine unterschiedliche Morphologie aufweist.

Damit wird im Gegensatz zu den Einkristallen auf polykristallinen oder amorphen technischen Substraten 1 mit ISD-Pufferschicht 2 mit oder ohne Deckschicht 3 auch eine deutliche Erhöhung der kritischen Stromdichte erreicht.

Es kann sogar schon eine substantielle Verbesserung der supraleitenden Eigenschaften dadurch erzielt werden, dass nicht die gesamte Schicht, sondern nur eine dünne Zwischenschicht 4b von ca. 5-100 nm Dicke aus einem Material mit großem Seltenerd-Atom zwischen dem Substrat und der eigentlichen XBCO Funktionsschicht 5 verwendet wird. Besonders eindrucksvoll ist dabei, dass selbst das nicht supraleitende PrBCO (Ionenradius 1,13 Å) eine Verbesserung der HTS-Schichtqualität bewirken kann.

Die Tatsache, dass selbst dünne Zwischenschichten 4b zur Verbesserung der Stromtragfähigkeit ausreichen, kann zur Erzielung großer Schichtdicken vorteilhaft sein. Unterschiedliche thermische Ausdehnungen von Substrat und Dünnschicht führen ab einer sogenannten kritischen Schichtdicke zur Rissbildung. Diese kritische Schichtdicke ist materialabhängig und auf Saphir beispielsweise für YBCO viermal so hoch wie für NdBCO. Die Verwendung eines YBCO/NdBCO-Schichtaufbaus lässt damit auf Saphir oder einer Al₂O₃-Keramik eine wesentlich höhere Gesamtdicke zu als bei Verwendung einer reinen NdBCO-Schicht. Die Möglichkeit der Beschränkung auf eine dünne Zwischenschicht 4b stellt für die Abstimmung des Schichtsystems auf das jeweilige Substrat einen großen Vorteil dar.

Als Seltene Erde bietet sich bevorzugt das Neodym an. NdBCO erreicht die höchste Sprungtemperatur von allen dem YBCO homologen Verbindungen. Mit thermischem Ko-Verdampfen auf MgO-Einkristallen mit 600 nm dicken Dünnschichten werden Werte von T_{c} ≈ 94 K und j_{c} ≈ 3 MA/cm² erreicht.

Die Abscheidung auf ISD-Substraten zeigt eine starke Verbesserung der Stromtragfähigkeit. Die kritischen Stromdichten sind mit 1,8 MA/cm² etwa doppelt so hoch wie in YBCO-Dünnschichten. Die Sprungtemperatur steigt auf 94 K an. Das bedeutet, dass auch die erwähnte T_{c}-Unterdrückung durch Verwendung von NdBCO vollständig verschwindet.

Eine weitere Verbesserung der kritischen Stromdichte ergibt sich, wenn das Neodym ganz oder teilweise durch Lanthan oder Praseodym substituiert wird, da diese noch größere Ionenradien besitzen.

Im folgenden werden weitere bevorzugte Ausführungsbeispiele der vorliegenden Erfindung dargestellt.

### 1. Ausführungsbeispiel

Auf einem polykristallinen Metallband 1 (z.B. Edelstahl, Hastelloy) wird mit Hilfe des ISD-Verfahrens eine orientierte Pufferschicht 2 aufgebracht. Anschließend wird eine bis zu mehrere Mikrometer dicke HTS-Schicht 4a aus RBCO (RBa₂Cu₃O₇) aufgebracht.

### 2. Ausführungsbeispiel

Auf einer polykristallinen Keramik 1 (z.B. Al₂O₃, YSZ, MgO) wird mit Hilfe des ISD-Verfahrens eine orientierte Pufferschicht 2 aufgebracht. Anschließend wird eine HTS-Schicht 4a aus RBCO (RBa₂Cu₃O₇) aufgebracht.

### 3. Ausführungsbeispiel

Auf einem polykristallinen Metallband 1 (z.B. Edelstahl, Hastelloy) wird mit Hilfe des ISD-Verfahrens eine orientierte Pufferschicht 2 aufgebracht. Anschließend wird eine dünne Zwischenschicht 4b aus RBCO (RBa₂Cu₃O₇) aufgebracht. Auf diese Zwischenschicht 4b wird eine bis zu mehrere Mikrometer dicke HTS-Schicht 5 aus XBCO aufgebracht.

### 4. Ausführungsbeispiel

Auf einer polykristallinen Keramik 1 (z.B. Al₂O₃, YSZ, MgO) wird mit Hilfe des ISD-Verfahrens eine orientierte Pufferschicht 2 aufgebracht. Anschließend wird eine dünne Zwischenschicht 4b aus RBCO (RBa₂Cu₃O₇) aufgebracht. Auf diese Zwischenschicht wird eine bis zu mehrere Mikrometer dicke HTS-Schicht 5 aus XBCO aufgebracht.

### Bezugszeichenliste

- 1: Substrat
- 2: Pufferschicht
- 3: ISD-Deckschicht
- 4a: RBCO Schicht
- 4b: RBCO Keimschicht
- 5: XBCO Funktionsschicht

## Patentansprüche

1. Verfahren zur Herstellung einer Hochtemperatur-Supraleiterschicht auf einem Substrat (1), **gekennzeichnet durch** die folgenden Herstellungsschritte:
a) Versehen eines polykristallinen oder amorphen Substrats (1) mit einer biaxial texturierten Pufferschicht (2) mittels Beschichtung unter schräger Depositionsrichtung (ISD);
b) Aufbringen einer Schicht (4a, 4b) umfassend RBCO, wobei R ein Element der Ordnungszahl 57-64 oder eine Mischung aus zumindest zweien dieser Elemente ist.

2. Verfahren nach Anspruch 1, wobei R eines der Elemente La, Pr, Nd, Sm, Eu oder Gd ist oder eine Mischung aus zumindest zweien dieser Elemente ist.

3. Verfahren nach einem der Ansprüche 1 oder 2, wobei R Nd ist.

4. Verfahren nach einem der Ansprüche 1 - 3, wobei die Schicht (4a, 4b) ferner Yttrium aufweist.

5. Verfahren nach einem der Ansprüche 1 - 4, wobei oberhalb der RBCO-Schicht (4b) mindestens eine weitere Schicht (5) umfassend XBCO aufgebracht wird, wobei X ein Element mit der Ordnungszahl 57-71, Yttrium oder eine Mischung aus zumindest zweien dieser Elemente ist.

6. Verfahren nach Anspruch 5, wobei X eines der Elemente La, Nd, Sm, Eu oder Gd ist oder eine Mischung aus zumindest zweien dieser Elemente ist.

7. Verfahren nach Anspruch 5, wobei X Yttrium ist.

8. Verfahren nach einem der Ansprüche 5 - 7, wobei die RBCO-Schicht (4b) als eine Keimschicht und die XBCO-Schicht als eine Funktionsschicht (5) wirkt.

9. Verfahren nach einem der Ansprüche 5 - 8, wobei die RBCO-Schicht (4b) mit einer Dicke von 5-100 nm aufgebracht wird.

10. Verfahren nach einem der Ansprüche 1 - 9, wobei zwischen der Pufferschicht (2) und der RBCO-Schicht (4b) eine biaxial texturierte Deckschicht (3) aufgebracht wird.

11. Verfahren nach einem der Ansprüche 1 - 9, wobei die RBCO-Schicht (4b) unmittelbar auf die Pufferschicht (2) aufgebracht wird.

12. Verfahren nach einem der Ansprüche 1 - 11, wobei die Hochtemperatur-Supraleiterschicht eine kritische Stromdichte von mindestens 1 MA/cm² aufweist.

13. Hochtemperatur-supraleitende Schichtstruktur aufweisend:
a) ein polykristallines oder amorphes Substrat (1);
b) eine biaxial texturierte Pufferschicht (2), die mittels Beschichtung unter schräger Depositionsrichtung (ISD) auf das Substrat (1) aufgebracht wurde; und
c) eine Schicht (4a, 4b) umfassend RBCO auf der Pufferschicht (2), wobei R ein Element der Ordnungszahl 57-64 oder eine Mischung aus zumindest zweien dieser Elemente ist.

14. Hochtemperatur-supraleitende Schichtstruktur nach Anspruch 13, wobei R eines der Elemente La, Pr, Nd, Sm, Eu oder Gd ist oder eine Mischung aus zumindest zweien dieser Elemente ist.

15. Hochtemperatur-supraleitende Schichtstruktur nach einem der Ansprüche 13 oder 14, wobei R Nd ist.

16. Hochtemperatur-supraleitende Schichtstruktur nach einem der Ansprüche 13 - 15, wobei die Schicht (4a, 4b) ferner Yttrium aufweist.

17. Hochtemperatur-supraleitende Schichtstruktur nach einem der Ansprüche 13 - 16, wobei oberhalb der RBCO-Schicht (4b) eine Schicht (5) aufweisend XBCO folgt, wobei X ein Element der Ordnungszahl 57-71, Yttrium oder eine Mischung aus zumindest zweien dieser Elemente ist.

18. Hochtemperatur-supraleitende Schichtstruktur nach Anspruch 17, wobei X eines der Elemente La, Nd, Sm, Eu oder Gd ist oder eine Mischung aus zumindest zweien dieser Elemente ist.

19. Hochtemperatur-supraleitende Schichtstruktur nach Anspruch 18, wobei X Yttrium ist.

20. Hochtemperatur-supraleitende Schichtstruktur nach einem der Ansprüche 17 - 19, wobei die RBCO-Schicht (4b) als eine Keimschicht und die XBCO-Schicht als eine Funktionsschicht (5) wirkt.

21. Hochtemperatur-supraleitende Schichtstruktur nach einem der Ansprüche 17 - 20, wobei die RBCO-Schicht (4b) eine Dicke von 5-100 nm aufweist.

22. Hochtemperatur-supraleitende Schichtstruktur nach einem der Ansprüche 13 - 21, wobei zwischen der Pufferschicht (2) und der RBCO-Schicht (4b) eine biaxial texturierte Deckschicht (3) angeordnet ist.

23. Hochtemperatur-supraleitende Schichtstruktur nach einem der Ansprüche 13 - 21, wobei die RBCO-Schicht (4b) unmittelbar auf der Pufferschicht (2) angeordnet ist.

24. Hochtemperatur-supraleitende Schichtstruktur nach einem der Ansprüche 13 - 23, wobei die Hochtemperatur-Supraleiterschicht eine kritische Stromdichte von mindestens 1 MA/cm² aufweist.

25. Hochtemperatur-supraleitende Schichtstruktur nach einem der Ansprüche 13 - 24, wobei das Substrat (1) eine polykristalline Keramik, insbesondere Al₂O₃, YSZ oder MgO, umfasst.

26. Hochtemperatur-supraleitende Schichtstruktur nach einem der Ansprüche 13 - 25, wobei das Substrat (1) ein polykristallines Metallband, insbesondere ein Edelstahlband oder Hastelloyband, umfasst.
